# EUROPEAN PATENT SPECIFICATION

(11) **EP 0 938 836 B1**
(45) Date of publication and mention of the grant of the patent: **14.03.2001**
(21) Application number: 97911153.1
(22) Date of filing: 05.11.1997
(51) Int. Cl.: H05K 7/14, H05K 1/14, H05K 7/20, H01R 12/16

(54) **A BOARD MAGAZINE FOR PRINTED CIRCUIT BOARDS**
MAGAZIN FÜR LEITERPLATTEN
MAGASIN POUR CARTES A CIRCUIT IMPRIME

(30) Priority: 06.11.1996 DK 124796
(43) Date of publication of application: 01.09.1999
(73) Proprietor: TELLABS DENMARK A/S, 2750 Ballerup (DK)
(72) Inventor: DAUGAARD, Kim, DK-4000 Roskilde (DK)
(74) Representative: Boesen, Johnny Peder
(86) International application number: DK9700506
(87) International publication number: WO9820717

(56) References cited:
- US-A- 4 755 146
- PATENT ABSTRACTS OF JAPAN, Vol. 18, No. 518, (E-1612); & JP,A,06 181 372 (MITSUBISHI ELECTRIC CORP) 28 June 1994.

## Description

The present invention relates to a board magazine for printed circuit boards and more specifically to a board magazine for holding a plurality of printed circuit boards in an operative array with electrical connections between the printed circuit boards and to the surroundings.

In larger electronic systems, it is common to build the systems on a plurality of printed circuit boards arranged in holders from which the printed circuit boards can be removed and exchanged individually, and in which the printed circuit boards, when inserted, obtain electrical connections through a plug expediently arranged at an edge of the printed circuit board. The mating part of the printed circuit board plug may expediently be provided on a special printed circuit board which will be fixedly mounted in the magazine in many cases.

It is expedient to arrange the printed circuit boards such that they are vertical and mutually parallel with air gaps between them, thereby achieving a natural cooling air circulation, provided the magazine itself is formed with suitable openings. If the fixed printed circuit board connection is likewise arranged vertically, it is ensured that said connection will not obstruct the air circulation.

The document JP 6-18 13 72 A discloses a printed circuit board arrangement comprising a mother board which is slightly inclined and which has downwardly directed, vertically arranged printed circuit boards mounted thereon. It is stated that the stepped arrangement gives room for the storage of cables, and it is mentioned that the non-used space contributes to the heat dissipation.

The prior art comprises board magazines for a large number of printed circuit boards held such that they are arranged in a pattern forming two stacks - one stack of vertical printed circuit boards and one stack of horizontal printed circuit boards - said two stacks interfacing at a partition panel, said printed circuit boards having plug connections to the partition panel. This arrangement makes it relatively simple to provide connections between all the printed circuit boards, as any printed circuit board in one stack has a point of intersection adjacent any one of the boards in the other stack where direct connections may be established through plugs.

In this known arrangement, cooling of the printed circuit boards in the vertical stack is favoured by the natural air circulation. This, however, does not apply to the printed circuit boards in the opposite stack in which they are positioned horizontally. These printed circuit boards have quite different thermal conditions, and in practice it is necessary to provide for forced air circulation to achieve satisfactory cooling of the boards in the other stack.

The invention provides a board magazine as defined in claim 1.

With this board magazine, the printed circuit boards in both magazines will be cooled by natural air circulation.

According to expedient embodiments, the board magazine may be arranged completely symmetrically so that the conditions are the same for the printed circuit boards in both stacks. For example, all boards may stand at an angle of 45° to the horizontal, except the partition panel which is vertical. However, the invention does not have a perfectly symmetrical arrangement as a necessary prerequisite; in practice, natural air circulation is achieved already at a smaller angle to the horizontal.

The inclined arrangement of the printed circuit boards in both board magazines implies that within an ordinary rack having horizontal and vertical partition faces there will be some corner areas which cannot be filled with printed circuit boards. However, these corner areas may expediently be used for electronic equipment which does not have to be provided on exchangeable printed circuit boards; e.g. cable connections, power supplies, etc., and therefore these corners do not necessarily represent wasted space. Compared with the prior art, a further space saving is achieved in that blowers for cooling need not be provided.

According to expedient embodiments, the partition panel is provided with electric plugs for each individual printed circuit board and with a suitable system of conductor paths which interconnect the individual plugs, no matter whether they are provided on the same side or opposite sides of the partition panel.

Further details and advantages of the invention will appear from the following description of an embodiment thereof given with reference to the drawings, in which
fig. 1 is a vertical front view of a rack having a magazine according to the invention,
fig. 2 is an isometric view illustrating the orientation of some printed circuit boards within the magazine of fig. 1, and
fig. 3 is a front view of a plug connection used in the magazine.

All figures are schematic and simplified and not necessarily to scale. The figures only show details which are essential to the understanding of the invention, while details of a routine nature are left out for clarity. The same reference numerals are used in all figures for identical or corresponding items.

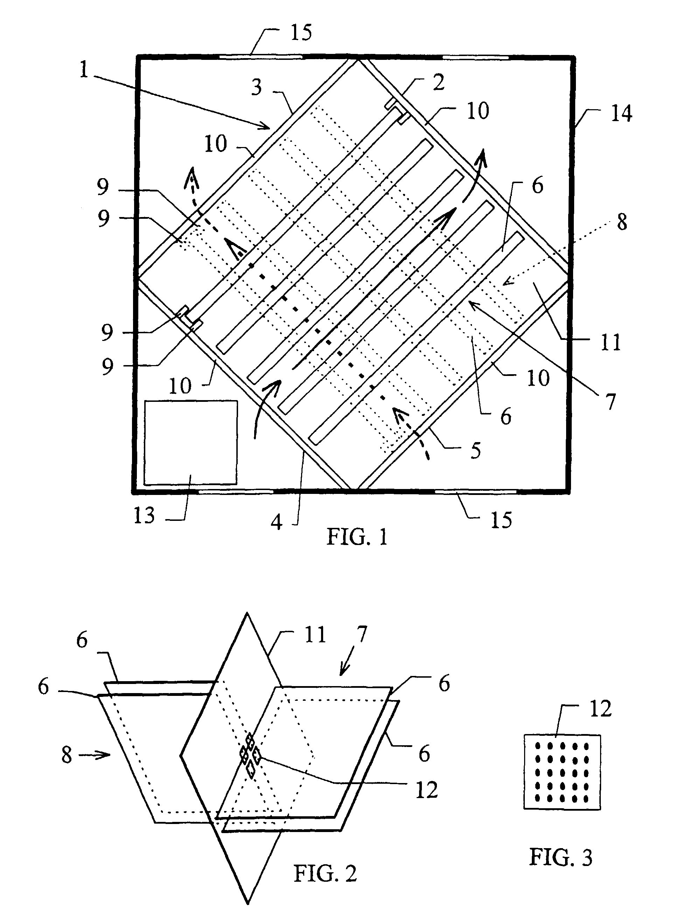

Reference is first made to figure 1 which shows a front view of a board magazine 1 according to the invention. The magazine is provided in an ordinary rack 14 defining a box-shaped volume available for the individual board magazines. This box-shaped volume is traditionally formed with horizontal and vertical faces. It is important according to the invention that this magazine makes room for natural air circulation either through the top and bottom faces or optionally through openings in the side faces or in the front and rear faces.

The board magazine 1 is shown in figure 1 in an outline which is a square standing on the tip, the sides of the square being designated by the reference numerals 2, 3, 4 and 5. The magazine comprises a support frame 10 which holds a plurality of printed circuit boards 6 by board rails 9. The printed circuit boards 6 shown in front view in figure 1 extend obliquely from the side edge at the bottom left-hand side with the reference numeral 4 to the side edge at the top right-hand side with the reference numeral 2 in figure 1. The printed circuit boards are inserted from the front and obtain plug connection at the partition panel 11 which is fixedly mounted in the board magazine. The printed circuit boards mentioned here together form the front stack 7 of boards.

Analogously, a plurality of printed circuit boards are inserted from behind, as seen in figure 1, to achieve plug connection with the partition panel 11. The printed circuit boards inserted from the rear are likewise seated in board rails 9 supported by the support frame 10, and they are inclined so as to extend from the side edge at the bottom right-hand side in figure 1 (the reference numeral 5) to the side face at the top left-hand side in figure 1 (reference numeral 3). These printed circuit boards are indicated by the dashed line in figure 1. The boards inserted from the rear together form the rear stack 8 of boards.

It is indicated in figure 2 how the individual printed circuit boards in the front and rear stacks of boards have points of intersection with the printed circuit boards in the opposite stack. In the preferred embodiment, the printed circuit boards do not touch each other directly, but have individual contact at a board plug 12 engaging with a corresponding plug connection on the partition panel 11. The partition panel 11 has electrical connections between the individual plugs.

Figure 3 is a front view of a board plug 12 having 25 pins which may be provided on each of the printed circuit boards according to the invention.

As indicated in figure 1, various fixed components 13, which may e.g. be cable connections, power supplies or the like, are arranged at the four corners where the printed circuit boards do not occupy the space completely. These components are merely to make room for natural air circulation which occurs in the heating of the various components, the fixed ones as well as the components on the printed circuit boards. In the front stack of boards, the air circulation moves upwards from the bottom left corner in figure 1 to the top right corner, while the air flow in the rear stack of boards moves upwards from the bottom right corner to the top left corner.

Although a specific embodiment has been described above, this merely serves to exemplify and not to restrict its scope which is defined by the appended claims.

## Claims

1. A board magazine for printed circuit boards, comprising holders (9,10) adapted to hold a plurality of substantially planar parallel printed circuit boards (6) in a pattern forming two stacks (7,8), wherein each stack comprises two or more printed circuit boards arranged mutually in parallel, wherein an edge of the boards in one stack faces toward and is perpendicular to an edge of the boards in the other stack, and wherein electrical connections may be provided from any board in one stack to one or more boards in the other stack, the holders being adapted to hold the printed circuit boards in a position of use such that the printed circuit boards are inclined with respect to the horizontal.

2. A board magazine according to claim 1, **characterized** in that the holders are adapted to hold the printed circuit boards in both stacks so that each printed circuit board has an edge substantially adjoining a boundary face which is perpendicular to the boards and is common to all the boards.

3. A board magazine according to claim 1, **characterized** in that the holders are adapted to hold the printed circuit boards in one stack perpendicular to the boards in the other stack.

4. A board magazine according to claim 1, **characterized** in that the holders are adapted to hold the printed circuit boards in the two stacks at substantially equal angles to the horizontal.

5. A board magazine according to claim 2, **charac** **terized** in that it is adapted such that the printed circuit boards in each of the stacks are removable by displacement away from the boundary face.

6. A board magazine according to claim 5, **characterized** in that it comprises a partition panel (11) forming the boundary face and provided with plug connections on both sides to obtain electrical connection to board plugs (12) of the inserted printed circuit boards in both stacks.

7. A board magazine according to claim 6, **characterized** in that the partition panel comprises electrical connections for mutual connections between the board plugs (12) for the respective printed circuit boards.

## Patentansprüche

1. Plattenmagazin für Leiterplatten, umfassend Halter (9, 10), die angepasst sind, um eine Mehrzahl von im Wesentlichen ebenen parallelen Leiterplatten (6) in einem Muster zu halten, das zwei Stapel (7, 8) bildet, wobei jeder Stapel zwei oder mehr Leiterplatten umfasst, die parallel zueinander angeordnet sind, wobei ein Rand der Platten in einem Stapel einem Rand der Platten in dem anderen Stapel zugekehrt ist und dazu senkrecht ist und wobei elektrische Verbindungen von einer beliebigen Platte in einem Stapel zu einer oder mehreren Platten im anderen Stapel vorgesehen sein können, wobei die Halter angepasst sind, um die Leiterplatten in einer solchen Gebrauchsstellung zu halten, dass die Leiterplatten in Bezug zur Horizontalen geneigt sind.

2. Plattenmagazin nach Anspruch 1, dadurch gekennzeichnet, dass die Halter angepasst sind, um die Leiterplatten in beiden Stapeln so zu halten, dass jede Leiterplatte einen Rand aufweist, der im Wesentlichen an einer Begrenzungsfläche angrenzt, die zu den Platten senkrecht ist und sämtlichen Platten gemeinsam ist.

3. Plattenmagazin nach Anspruch 1, dadurch gekennzeichnet, dass die Halter angepasst sind, um die Leiterplatten in einem Stapel senkrecht zu den Platten in dem anderen Stapel zu halten.

4. Plattenmagazin nach Anspruch 1, dadurch gekennzeichnet, dass die Halter angepasst sind, um die Leiterplatten in den beiden Stapeln unter im Wesentlichen gleichen Winkeln zur Horizontalen zu halten.

5. Plattenmagazin nach Anspruch 2, dadurch gekennzeichnet, dass es so angepasst ist, dass die Leiterplatten in jedem der Stapel durch Verlagerung weg von der Begrenzungsfläche entfernbar sind.

6. Plattenmagazin nach Anspruch 5, dadurch gekennzeichnet, dass es umfasst: eine Trennplatte (11), die die Begrenzungsfläche bildet und auf beiden Seiten mit Steckverbindungen versehen ist, um eine elektrische Verbindung mit Plattensteckern (12) der eingesetzten Leiterplatten in beiden Stapeln zu erhalten.

7. Plattenmagazin nach Anspruch 6, dadurch gekennzeichnet, dass die Trennplatte elektrische Verbindungen für gegenseitige Verbindungen zwischen den Plattensteckern (12) für die jeweiligen Leiterplatten umfasst.

## Revendications

1. Magasin à cartes, pour cartes à circuit imprimé, comprenant des supports (9, 10) adaptés de façon à maintenir une pluralité de cartes à circuit imprimé (6) parallèles, sensiblement planes, selon un motif formant deux piles (7, 8), dans lequel chaque pile comprend deux cartes à circuit imprimé, ou plus, agencées mutuellement parallèlement, dans lequel un bord des cartes d'une pile est tourné vers et est perpendiculaire à un bord des cartes de l'autre pile, et dans lequel des connexions électriques peuvent être établies depuis une carte quelconque d'une pile à une ou plusieurs cartes de l'autre pile, les supports étant adaptés de façon à maintenir les cartes à circuit imprimé dans une position d'utilisation telle, que les cartes à circuit imprimé sont inclinées par rapport à l'horizontale.

2. Magasin à cartes selon la revendication 1, caractérisé en ce que les supports sont adaptés de façon à maintenir les cartes à circuit imprimé en deux piles, de manière que chaque carte à circuit imprimé présente un bord rejoignant sensiblement une face de délimitation qui est perpendiculaire aux cartes et est commune à toutes les cartes.

3. Magasin à cartes selon la revendication 1, caractérisé en ce que les supports sont adaptés de manière à maintenir les cartes à circuit imprimé d'une pile perpendiculairement aux cartes de l'autre pile.

4. Magasin à cartes selon la revendication 1, caractérisé en ce que les supports sont adaptés de manière à maintenir les cartes à circuit imprimé des deux piles sous des angles sensiblement identiques par rapport à l'horizontale.

5. Magasin à cartes selon la revendication 2, caractérisé en ce qu'il est adapté de manière que les cartes à circuit imprimé de chacune des piles puissent être enlevées par un déplacement par éloignement vis à vis de la face de délimitation.

6. Magasin à cartes selon la revendication 5, caractérisé en ce qu'il comprend un panneau de séparation (11) formant la face de délimitation et pourvu, des deux côtés, de connexions à fiche pour obtenir une connexion électrique avec les fiches de carte (12) des cartes à circuit imprimé des deux piles.

7. Magasin à cartes selon la revendication 6, caractérisé en ce que le panneau de séparation comprend des connexions électriques pour des connexions mutuelles entre les fiches de carte (12) pour les cartes à circuit imprimé respectives.
